# EUROPÄISCHE PATENTSCHRIFT

(11) **EP 3 887 767 B1**
(45) Veröffentlichungstag und Bekanntmachung des Hinweises auf die Patenterteilung: **21.08.2024**
(21) Anmeldenummer: 19817952.5
(22) Anmeldetag: 25.11.2019
(51) Int. Cl.: G01D 21/02, H01M 50/216, H01R 13/629, H01R 13/66, G01L 19/08

(54) **MESSEINRICHTUNG FÜR BETRIEBSZUSTAND**
MEASURING APPARATUS FOR OPERATING STATE
SYSTÈME DE MESURE D'UN ÉTAT DE FONCTIONNEMENT

(30) Priorität: 30.11.2018 DE 102018130509
(43) Veröffentlichungstag der Anmeldung: 06.10.2021
(73) Patentinhaber: HARTING Electric Stiftung & Co. KG, 32339 Espelkamp (DE)
(72) Erfinder: FRIESEN, Markus, 32339 Espelkamp (DE); LOSKE, Felix, 32425 Minden (DE)
(86) Internationale Anmeldenummer: PCT/DE2019/101007
(87) Internationale Veröffentlichungsnummer: WO 2020/108698

(56) Entgegenhaltungen:
- WO-A1-2015/099777
- DE-U1- 202007 018 305
- DE-U1- 202007 018 307
- US-A1- 2010 178 806
- US-A1- 2010 194 382
- US-A1- 2015 268 069
- US-A1- 2018 086 213

## Beschreibung

Die Erfindung betrifft eine Vorrichtung, aufweisend ein Gehäuse mit einer nicht verwendeten Kabeldurchführung und eine Hard- und Softwaregestützte Messeinrichtung zur Überwachung des Betriebszustands der Vorrichtung.

Eine zu überwachende Vorrichtung kann beispielsweise eine Maschine und/oder ein Schaltschrank und/oder ein Steckverbinder und/oder eine größere Installationseinheit einer Vielzahl von beispielsweise Steckverbindern sein.

Steckverbinder werden benötigt, um Verbindungen zur Signal- und/oder Energieübertragung auch zum Betrieb essentieller Einrichtungen, wie beispielsweise Versorgungseinrichtungen herzustellen. Verbindungen von beispielsweise elektrischen, pneumatischen oder optischen Signalen sind sensibel insbesondere auch gegenüber Umwelteinflüssen. Daher ist wünschenswert, den Betriebszustand der Verbindungen eines Steckverbinders und/oder eines Schaltschranks mit einer Vielzahl von Steckverbindern und auch von größeren Installationseinheiten mit einer Vielzahl von Steckverbindern insbesondere essentieller Einrichtungen zu überwachen.

### Stand der Technik

Aus der DE 20 2007 018 306 U1 ist eine Messeinrichtung zur messtechnischen Erfassung einer Vielzahl physikalischer Messparameter für eine Steckverbindung eines modularen Steckverbinders bekannt. Die Messeinrichtung ist in einem ersten Modulgehäuse des Steckverbinders vorgesehen. Zur Signalübermittlung und Energieversorgung der Messeinrichtung ist eine Kontakteinheit in einem zweiten benachbarten Modulgehäuse vorgesehen, die die Signale mittels elektrischer Leiter an eine Kontrolleinrichtung weiterleitet.

Die bekannte Messeinrichtung beansprucht zwei Modulgehäuse eines Steckverbinders, wonach die mögliche Belegung bzw. Konfiguration des Steckverbinders und damit auch dessen Einsatzmöglichkeit nachteilhaft eingeschränkt ist. Dementsprechend sind auch die Einsatzmöglichkeiten der Messeinrichtung, auf Steckverbinder mit zwei freien benachbarten Modulplätzen beschränkt. Aus diesem Grund ist die bekannte Messeinrichtung auch nur nachteilhaft aufwendig und entsprechend kostspielig nachrüstbar. Dies ist insbesondere auch der Fall, nachdem die Messeinrichtung für Ihre Energieversorgung und Signalübermittlung verkabelt und entsprechend aufwendig zu installieren ist.

Das Deutsche Patent- und Markenamt hat in der Prioritätsanmeldung zu vorliegender Anmeldung den folgenden Stand der Technik recherchiert: DE 10 2011 075 807 A1, DE 20 2007 018 306 U1 und DE 20 2009 001 447 U1.

Aus der DE 20 2007 018 307 U1 ist eine Messeinrichtung für Steckverbinder bekannt, die in einem Steckerverbindergehäuse angeordnet ist, in dem ein oder mehrere elektrische Kontakte in dazu vorgesehenen Aufnahmeöffnungen eines Kontakteinsatzes angeordnet sind. Die Messeinrichtung ist dafür vorgesehen, einige physikalische Messparameter, die für eine Steckverbindung wie für eine größere Installationseinheit relevant sein können, messtechnisch zu erfassen. Hierfür ist einem oder mehreren elektrischen Kontakten im Kontakteinsatz mindestens ein Messsensor mit einer Auswerteeinheit der als Baugruppe ausgebildeten Messeinrichtung zugeordnet, wobei die als MID Trägerelement ausgebildete Baugruppe in einer Gehäusewand mit der Außenwand fluchtend eingesetzt ist. Die Anordnung erfolgt mittels einer Klebung oder dem Einschieben des Baugruppenträgers in eine entsprechende Vertiefung oder eines Verrastungsmechanismus auf der Innenseite des Steckverbindergehäuses.

Aus der US 2010/0178806 A1 ist ein Koaxialkabelverbinder und ein Verfahren zum Ermitteln des Zustands einer Verbindung des Koaxialkabelverbinders mit einem HF-Port bekannt. Der Koaxialkabelverbinder umfasst einen Verbinderkörper und einen Statusmessschaltkreis für einen physikalischen Parameter, der innerhalb des Verbinderkörpers angeordnet ist. Der Statusmessschaltkreis für einen physikalischen Parameter ist vorgesehen, um einen Zustand des Verbinders zu messen, wenn dieser mit dem RF-Anschluss verbunden ist. Der Verbinderkörper weist außerdem eine Statusausgabekomponente auf, die elektrisch mit dem Messschaltkreis und einer Steuerlogikeinheit verbunden ist. Die Steuerlogikeinheit ist mit dem Messschaltkreis und der Statusausgabekomponente verbunden, und die Statusausgabekomponente steht in elektrischer Verbindung mit einem zentralen Leiter, um das Berichten des gemessenen Zustands des Verbinders zu ermöglichen.

### Aufgabenstellung

Die Aufgabe der Erfindung besteht darin, eine einfach und kostengünstig zu installierende und nachrüstbare Messeinrichtung zur Überwachung des Betriebszustands einer Vorrichtung bereitzustellen, die insbesondere auch zur Überwachung auch von größeren Installationseinheiten geeignet ist.

Dabei ist insbesondere Aufgabe der Erfindung eine Messeinrichtung zur Überwachung des Betriebszustands der Verbindungen eines Steckverbinders bereitzustellen.

Die Aufgabe wird durch die Merkmale des unabhängigen Anspruchs gelöst.

Vorteilhafte Ausgestaltungen der Erfindung sind in den abhängigen Ansprüche angegeben.

Die vorliegende Erfindung betrifft eine Vorrichtung gemäß Anspruch 1, die insbesondere eine Maschine und/oder ein Schaltschrank und/oder ein Steckverbinder und/oder eine größere Installationseinheit einer Vielzahl von beispielsweise Steckverbindern sein kann.

Die Vorrichtung weist ein Gehäuse mit einer nicht verwendeten Kabeldurchführung und eine Hard- und Softwaregestützte Messeinrichtung auf.

Die Messeinrichtung weist wenigstens einen Sensor zur Erfassung von Messdaten wenigstens eines physikalischen Parameters auf, der den Betriebszustand der Vorrichtung charakterisiert.

Die Messeinrichtung weist dabei besonders vorteilhaft eine autarke Elektronik mit einer Steuereinheit und mit einem Mittel zur Energieversorgung auf, das geeigneter Weise eine Batterie, ein Superkondensator oder eine Hybridbatterie sein kann. Auf diese Weise benötigt die Messeinrichtung insbesondere auch für ihre Energieversorgung keine zusätzlichen Leitungen.

Die Messeinrichtung weist außerdem vorteilhaft eine Steuereinheit mit einem Mikrocontroller auf, der eine Funkschnittstelle zur Daten- und/oder Signalübertragung zu einer ersten Steuer- und/oder Auswerteeinrichtung bereitstellt, wonach die Messeinrichtung auch für ihre Daten- und/oder Signalübertragung keine zusätzlichen Leitungen benötigt.

Die Messeinrichtung ist daher einfach zu installieren und auf einfache Weise und kostengünstig ohne einen entsprechenden Installationsaufwand auch in bereits im Betrieb befindliche Vorrichtungen und/oder Installationseinrichtungen nachrüstbar.

Die Messeinrichtung weist hierfür geeigneter Weise ein für die nicht verwendete Kabeldurchführung durch das Gehäuse der Vorrichtung vorgesehenes und entsprechend als deren Blindstopfen ausgebildetes Gehäuse mit geeigneten Mitteln zur Befestigung der Messeinrichtung an der Vorrichtung auf.

Der Blindstopfen ist im Wesentlichen als Hohlzylinder ausgebildet ist, und weist ein Außengewinde aus, das dazu geeignet ist, mit einem Innengewinde der Kabeldurchführung der Vorrichtung derart zu korrespondieren und geschraubt zu werden, dass mittels dem Blindstopfen das Gehäuse der Vorrichtung dicht verschließbar ist.

Das Gehäuse der Messeinrichtung ist entsprechend mittels einem für die Vorrichtung vorgesehenen Blindstopfen bereitgestellt, in dem die Messeinrichtung zumindest teilweise beherbergt ist. Eine in einem Blindstopfen angeordnete Messeinrichtung ist besonders einfach und kostengünstig auch nachrüstbar zu installieren. Auch in bestehenden Installationen können bereits vorhandene Blindstopfen auf einfache Weise auch ohne Eingriffe in den Betrieb einer Vorrichtung, die eine Maschine sein kann und die besonders vorteilhaft ein Steckverbinder sein kann, ausgetauscht werden. Der Blindstopfen kann dabei ein erstes Gehäuse sein, in der die Messeinrichtung beherbergt ist. Der Blindstopfen kann auch ein zweites Gehäuse einer in einem ersten Gehäuse beherbergten Messeinrichtung sein, wobei das erste Gehäuse in dem Blindstopfen zumindest teilweise angeordnet ist.

Besonders vorteilhaft ist ein für die Messeinrichtung geeigneter Blindstopfen ein für eine nicht verwendete Kabeldurchführung durch ein Maschinengehäuse oder ein Steckverbindergehäuse vorgesehener Blindstopfen. Ein derartiger geeigneter Blindstopfen wird nachfolgend auch unter Bezugnahme auf die Zeichnungen detailliert beschrieben. Die vorstehend genannte Funkschnittstelle kann geeigneter Weise ein Kommunikationsprotokoll mit einem Energieverbrauch von weniger als 1W und vorzugsweise von weniger als 0.5W und besonders bevorzugt von weniger als 0.1W und einen Spitzenstromverbrauch von weniger als 30mA und vorzugsweise weniger als 15mA aufweisen. Ein derartiges und für die vorstehende Messeinrichtung besonders bevorzugtes Kommunikationsprotokoll ist BLE (Blue Tooth Low Energy).

Kommunikationsprotokolle mit einem vorstehenden Energieverbrauch und insbesondere BLE gestatten es, Daten effizient zu übermitteln und gleichzeitig Energiereserven zu schonen, indem sie lange Schlafenszeiten ermöglichen und energieintensive Bauteile wie die Funkschnittstelle möglichst selten ansprechen. Derartige Kommunikationsprotokolle und insbesondere BLE gestatten eine zuverlässige und robuste Signal- und/oder Datenübertragung zu einer Steuer- und/oder Auswerteeinrichtung über eine Entfernung von mindestens 10m und sind demnach auch für größere Installationseinheiten geeignet.

Geeigneter Weise kann die Steuereinheit zur Daten- und/oder Signalübertragung eine Chip-Antenne aufweisen, wonach die Messeinrichtung besonders kompakt ausgebildet ist und lediglich einen geringen Raumbedarf hat. Eine vorstehende Messeinrichtung mit einer derartigen Steuereinheit kann in einer vorteilhaft kompakten Raumform bereitgestellt werden, die im Wesentlichen durch die Abmessungen des Mittels zur Energieversorgung der Messeinrichtung, das eine Batterie sein kann, und/oder eines für die Messeinrichtung vorgesehenen Blindstopfens und/oder eines im Inneren eines Gehäuses einer zu überwachenden Vorrichtung und insbesondere eines Steckverbindergehäuses und/oder einer Kabeldurchführung zur Verfügung stehenden Raums vorgegeben ist.

Die Steuereinheit kann zur Daten- und/oder Signalübertragung weiterhin mit einer externen aus dem Gehäuse der Vorrichtung nach außen herausragenden Antenne verbunden sein, wodurch die Reichweite der Funkschnittstelle auch in unübersichtlichen größeren Installationen begünstigt wird.

Geeigneter Weise kann die Steuereinheit mit einer Busschnittstelle ausgestattet sein, mittels der der Sensor an die Steuereinheit angebunden ist. Vorteilhaft kann dabei der Sensor auf einer Sensoreinheit angeordnet sein, wobei die Steuereinheit mit der Sensoreinheit bestückt sein kann, und die Sensoreinheit über die Busschnittstelle von der Steuereinheit angesprochen werden kann.

Die Elektronik der Steuereinheit und die Elektronik der Sensoreinheit können für eine Messeinrichtung mit kompakter Raumform zusammen auf einer ersten Leiterplatte bereitgestellt sein, was auch für eine außen an einem Gehäuse einer zu überwachenden Vorrichtung vorgesehene und einfach zu installierende Messeinrichtung vorteilhaft ist.

Die Elektronik der Steuereinheit kann weiterhin auf einer ersten Leiterplatte bereitgestellt sein und einen ersten Anschluss aufweisen, und die Elektronik der Sensoreinheit kann auf einer zweiten Leiterplatte bereitgestellt sein und einen zweiten Anschluss aufweisen, der mit dem ersten Anschluss derart korrespondiert, dass die Steuereinheit mit der Sensoreinheit bestückbar ist.

Auf diese Weise kann vorteilhaft eine Vielzahl von unterschiedlichen Sensoreinheiten mit für vorbestimmte Anwendungen optimierten Sensoren und/oder Raumformen bereitgestellt werden. Dabei kann die Raumform der Sensoreinheit derart ausgebildet sein, dass der Sensor von der Steuereinheit beabstandet und vorteilhaft im Inneren des Gehäuses der zu überwachenden Vorrichtung auch in der Nachbarschaft einer interessierenden zu überwachenden Position angeordnet ist.

Auf diese Weise kann der Sensor besonders vorteilhaft im Inneren des Gehäuses eines zu überwachenden Steckverbinders in der Nähe wenigstens einer mittels dem Steckverbinder bereitgestellten Verbindung angeordnet sein.

Geeigneter Weise kann die Sensoreinheit mittels einem zwischen dem ersten und zweiten Anschluss vorgesehenen geeigneten Adapterkabel von der Steuereinheit beabstandet angeordnet sein. Auf diese Weise wird vorteilhaft die Möglichkeit geschaffen, den Sensor in unmittelbarer Nähe eines zu observierenden Bereichs, der insbesondere ein Kontaktbereich einer Steckverbindung sein kann, zu positionieren, wonach eine besonders sensible Überwachung von vorbestimmten zu überwachenden physikalischen Parametern ermöglicht ist.

Eine derartige zu observierende Steckverbindung kann insbesondere eine elektrische Steckverbindung sein. Beispielsweise kann mittels einem in der Nachbarschaft von in Verbindung gebrachten elektrischen Kontakten angeordneten Hall Sensor eine Strommessung besonders zuverlässig durchgeführt werden.

Neben der vorstehenden Funkschnittstelle und Busschnittstelle kann die Steuereinheit geeigneter Weise außerdem eine Einrichtung zur Datenspeicherung und/oder -Auswertung aufweisen.

Weiterhin können die Steuereinheit und die Sensoreinheit geeigneter Weise derart ausgebildet und eingerichtet sein, dass die Messeinrichtung eine durchschnittliche Leistungsaufnahme von weniger als 100µA und vorzugsweise von weniger als 50µA aufweist. Zur Energieversorgung einer derartigen Messeinrichtung kann vorteilhaft eine mittels einer Knopfzelle bereitgestellte Batterie mit einer Kapazität von mindestens 70 mAh und vorzugsweise mindestens 180 mAh und mit einer Nennspannung von 2,5V bis 4,5V verwendet werden.

Eine vorstehende Batterie hat eine vorteilhaft kompakte Bauform eines flachen Zylinders und ermöglicht bei der vorstehenden geeigneten Leistungsaufnahme der Elektronik der Messeinrichtung eine wünschenswerte Laufzeit von bis zu drei Jahren.

Die erste Leiterplatte der Steuereinheit kann dabei geeigneter Weise einen Batteriehalter zur Beherbergung der Batterie aufweisen und dabei für eine wünschenswert kompakte Raumform vorteilhaft kreisförmig mit einer Abmessung ausgebildet sein, die im Wesentlichen durch die Abmessung der Batterie vorgegeben ist. Der erste Anschluss der Steuereinheit kann dabei geeigneter Weise derart auf der ersten Leiterplatte vorgesehen sein, und eine auf einer zweiten Leiterplatte angeordnete Sensoreinheit kann dabei außerdem derart ausgebildet sein, dass die Sensoreinheit die Steuereinheit radial seitlich nicht überragt und der Sensor der Sensoreinheit wünschenswert axial von der Steuereinheit beabstandet ist.

Eine vorstehende Messeinrichtung kann darüber hinaus geeigneter Weise wenigstens einen Aktor zur Anzeige eines vorbestimmten erfassten/detektierten Betriebszustands und/oder zur Durchführung einer Aktion auf einen vorbestimmten Betriebszustand aufweisen. Beispielsweise und vorteilhaft kann ein derartiger Aktor eine LED zur optischen Anzeige eines vorbestimmten Betriebszustands sein, wobei die Anzeige einen fehlerfreien und/oder fehlerhaften und/oder kritischen Betriebszustand der Vorrichtung und/oder der Messeinrichtung anzeigen kann. Ein als eine LED ausgebildeter Aktor kann dabei von außen sichtbar an einem Gehäuse einer zu überwachenden Vorrichtung und insbesondere an einem vorstehend beschriebenen Blindstopfen angeordnet sein.

Ein kritischer Betriebszustand der Vorrichtung kann beispielsweise eine erhöhte Betriebstemperatur sein, und ein kritischer Betriebszustand der Messeinrichtung kann beispielsweise eine niedrige Kapazität des Mittels zur Energieversorgung wie beispielsweise eine niedrige Batterieladung sein.

Auf diese Weise ist auf einfache Weise die Möglichkeit der Identifikation und/oder Ortung einer beispielsweise in einem kritischen Betriebszustand befindlichen und/oder zu wartenden Vorrichtung bereitgestellt.

Ein vorstehender Aktor kann weiterhin beispielsweise ein akustischer oder mechanischer Aktor sein, wobei ein mechanischer Aktor auf geeignete Weise eingerichtet und ausgebildet sein kann, den Betrieb einer Verbindung eines Steckverbinders zu unterbrechen.

Eine vorstehende Messeinrichtung kann einen für viele Anwendungen geeigneten Sensor aufweisen, der einen physikalischen Parameter erfasst, der geeignet ist, einen Betriebszustand einer zu überwachenden Vorrichtung und insbesondere der Verbindungen eines Steckverbinders charakterisierenden Zustand zu erfassen. Ein derartiger Sensor kann ein Sensor zur Erfassung der Stromstärke sein, die über Kontakte einer elektrischen Verbindung geführt wird, und/oder ein Sensor zur Erfassung der dabei herrschenden Temperatur sein und/oder ein Feuchtigkeitssensor und/oder ein Beschleunigungssensor und/oder ein Hall-Sensor und/oder ein Magnet Sensor und/oder ein Lichtsensor sein. Eine vorstehende Messeinrichtung kann dabei auch eine Vielzahl von derartigen vorstehenden Sensoren aufweisen.

Ein für eine erfindungsgemäße Messeinrichtung geeignetes Gehäuse und insbesondere ein geeigneter Blindstopfen ist wenigstens teilweise aus einem elektrisch nichtleitenden Material bereitgestellt, so dass eine zuverlässige Signal- und/oder Datenübertragung mittels der Funkschnittstelle der Steuereinheit der Messeinrichtung sichergestellt ist Ein für eine vorstehende Messeinrichtung besonders geeigneter

Blindstopfen ist mittels einem für eine Kabeldurchführung einer Kabelverschraubung durch das Gehäuse einer zu überwachenden Vorrichtung vorgesehenen Blindstopfen bereitgestellt und entsprechend ausgebildet. Ein besonders geeigneter Blindstopfen kann insbesondere mittels einem für eine Kabeldurchführung einer Kabelverschraubung durch das Gehäuse eines Steckverbinders vorgesehenen Blindstopfen bereitgestellt sein und entsprechend ausgebildet sein. Derartige Blindstopfen können auf besonders einfache Weise auch in bereits Betrieb befindliche Installationen nachgerüstet werden.

Ein weiteres nicht beanspruchtes Beispiel betrifft ein hard- und softwaregestütztes Verfahren zur Überwachung des Betriebszustands einer Vorrichtung, die eine Maschine und/oder ein Schaltschrank und/oder ein Steckverbinder und/oder eine größere Installationseinheit sein kann, unter Verwendung wenigstens einer Messeinrichtung mit wenigstens einem Sensor zur Erfassung von Messdaten wenigstens eines physikalischen Parameters, der den Betriebszustand der Vorrichtung charakterisiert. Die verwendete Messeinrichtung hat dabei eine elektronische Steuereinheit mit einem Mikrokontroller, der eine Funkschnittstelle aufweist.

Bei dem vorstehenden Verfahren wird außerdem eine erste hard- und softwaregestützte Steuer- und/oder Auswerteeinrichtung verwendet, die mit der Messeinrichtung zur Signal- und/oder Datenübertragung drahtlos verbunden ist.

Von der Messeinrichtung werden dabei Messdaten wenigstens eines physikalischen Parameters erfasst, der den Betriebszustand der Vorrichtung charakterisiert und wenigstens einer der nachfolgenden Schritte durchgeführt, die die Auswertung und/oder Sammlung und/oder Übertragung der von der Messeinrichtung erfassten Messdaten betreffen.

Für ausgewählte Anwendungen kann wünschenswert sein, die von der Messeinrichtung erfassten Messdaten von der Messeinrichtung zumindest teilweise auszuwerten. Dies kann insbesondere für kleinere Installationseinheiten von nur wenigen zu überwachenden Vorrichtungen mit einer entsprechend geringen Anzahl von Messeinrichtungen von Vorteil sein.

Beispielsweise kann bei der Überwachung lediglich einer Vorrichtung mittels auch vollständiger Auswertung der erfassten Messdaten bereits von der Messeinrichtung der Energieverbrauch der Messeinrichtung vorteilhaft minimiert werden, insbesondere auch nachdem hierbei eine Datenübertragung zu der ersten Steuer- und/oder Auswerteeinrichtung in entsprechend geringem Umfang durchgeführt werden kann. Der vorstehende vorteilhafte geringe Umfang der Durchführung der Datenübertragung kann deren Taktung und/oder den Umfang der übertragenen Daten und/oder Signale betreffen.

Bei vollständiger Auswertung der erfassten Messdaten seitens der Messeinrichtung kann auch lediglich ein die Auswertung kennzeichnendes Signal an die erste Steuer- und/oder Auswerteeinrichtung übertragen werden.

Für weitere ausgewählte Anwendungen kann wünschenswert sein, die von der Messeinrichtung erfassten Messdaten zu der ersten Steuer- und/oder Auswerteeinrichtung insbesondere auch gesammelt zu übertragen, wobei darüber hinaus geeigneter Weise die erste Steuer- und/oder Auswerteeinrichtung die von der Messeinrichtung erfassten Messdaten vorbestimmt zyklisch abfragen kann. Dies kann insbesondere für größere Installationseinheiten mit einer Vielzahl von überwachten Vorrichtungen mit einer entsprechend hohen Anzahl von Messeinrichtungen und/oder für kleinere sehr sensible Installationseinheiten von Vorteil sein.

Geeigneter Weise können dabei die von der Messeinrichtung erfassten Messdaten von der ersten Steuer- und/oder Auswerteeinrichtung auch gesammelt und/oder zumindest teilweise ausgewertet werden.

Die Sammlung und/oder Auswertung der Messdaten an einer zentralen Stelle, nämlich der ersten Steuer- und/oder Auswerteeinrichtung, gestattet eine umfangreiche auch weitergehende beispielsweise auch statistische Auswertung der Messdaten.

Darüber hinaus kann die erste Steuer- und/oder Auswerteeinrichtung wie nachfolgend beschrieben mit einer weiteren zweiten Steuer- und/oder Auswerteeinrichtung signal- und/oder datentechnisch vernetzt sein, so dass die ausgewerteten Messdaten und/oder ein Signal einer bereits durchgeführten Auswertung an eine vorbestimmte geeignete Einrichtung und/oder Position übertragen werden können und dort zur weiteren Auswertung zur Verfügung stehen. Hierdurch wird wie nachfolgend beschrieben die Möglichkeit einer vorteilhaften Wartung bereitgestellt, wobei als fehlerhaft erkannte Betriebszustände zeitnah erkannt und beispielsweise durch Austausch fehlerhafter Vorrichtungen behoben werden können.

Die zweite Steuer- und/oder Auswerteeinrichtung kann dabei geeigneter Weise mit einer Vielzahl von ersten Steuer- und/oder Auswerteeinrichtungen signal- und/oder datentechnisch vernetzt sein.

Die Messdaten können wie vorstehend gesagt von der Messeinrichtung und/oder der ersten Steuer- und/oder Auswerteeinrichtung dahingehend auswertet werden, dass ein beispielsweise fehlerhafter oder auch wünschenswerter Betriebszustand der überwachten Vorrichtung festgestellt wird.

Dabei können die Messdaten dahingehend auswertet werden, dass ein dem Auswerteergebnis entsprechendes Signal von der Messeinrichtung an einen Aktor erfolgt, der an ihrer Steuereinheit und/oder einer zu überwachenden Vorrichtung vorgesehen sein kann, wobei bei Auswertung der Messdaten seitens der ersten Steuer- und/oder Auswerteeinrichtung ein entsprechendes Signal an die Messeinrichtung erfolgen kann. Ein geeigneter Aktor kann beispielsweise eine optische Anzeige sein, wonach beispielsweise eine LED ein dem Auswerteergebnis entsprechenden erkannten Betriebszustand einer zu überwachenden Vorrichtung anzeigen kann.

Es ist klar, dass insbesondere bei größeren Installationseinheiten von der Messeinrichtung neben den Messdaten geeigneter Weise auch weitere Daten wie beispielsweise Identifikationsdaten der Messeinrichtung und/oder einer zu überwachenden Vorrichtung an die erste Steuer- und/oder Auswerteeinrichtung übertragen werden und/oder abgefragt werden können. Die Identifikationsdaten können auch zur gezielten Kommunikation der ersten Steuer- und/oder Auswerteeinrichtung mit einer ausgewählten Messeinrichtung dienen. Bei Messeinrichtungen mit einer autarken beispielsweise und vorteilhaft mittels einer Batterie mit Energie versorgten Elektronik können die vorstehenden zu der ersten Steuer- und/oder Auswerteeinrichtung übertragenen Daten und/oder Signale geeigneter Weise auch Daten über den Batteriezustand der Messeinrichtung beinhalten.

Bei dem Verfahren kann die Erfassung und/oder Sammlung und/oder Auswertung und/oder Abfragung und/oder Übertragung der Messdaten und/oder Signale von der Steuereinheit der Messeinrichtung und/oder der ersten Steuer- und/oder Auswerteeinrichtung geeigneter Weise derart durchgeführt werden, dass die Messeinrichtung eine durchschnittliche Leistungsaufnahme von weniger als 100µA und vorzugsweise von weniger als 50µA aufweist. Der vorstehende Betrieb der Messeinrichtung ist besonders energieeffizient und insbesondere für Messeinrichtungen mit einer autarken mittels einer Batterie mit Energie versorgten Elektronik von Vorteil, wonach eine derartige Messeinrichtung eine wünschenswert lange Lebensdauer hat.

Je nach Anwendung kann hierbei die vorstehende Erfassung und/oder Sammlung und/oder Auswertung und/oder Abfragung und/oder Übertragung der Messdaten und/oder Signale jeweils vorbestimmt ausgewählt getaktet auf die jeweilige Anwendung optimiert durchgeführt werden. Beispielsweise kann bei Messeinrichtungen mit einem aktiven Sensor in einer Installationseinheit von höherer Sensibilität und/oder Priorität dessen Aktivierung zur Durchführung einer Messung entsprechend höhergetaktet vorteilhaft sein.

Wie vorstehend erwähnt kann bei dem Verfahren darüber hinaus geeigneter Weise wenigstens eine zweite hard- und softwaregestützte Steuer- und/oder Auswerteeinrichtung verwendet werden, die mit der ersten Steuer- und/oder Auswerteeinrichtung zur Signal- und/oder Datenübertragung kabelgestützt und/oder drahtlos verbunden ist.

Die von der ersten Steuer- und/oder Auswerteeinrichtung gesammelten und/oder ausgewerteten Daten und/oder ein den ausgewerteten Daten entsprechendes Signal können dabei zu der zweiten Steuer- und/oder Auswerteeinrichtung übertragen werden und/oder von der zweiten Steuer- und/oder Auswerteeinrichtung abgefragt werden, wobei die Daten und/oder das Signal von der zweiten Steuer- und/oder Auswerteeinrichtung geeigneter Weise gesammelt und/oder ausgewertet werden.

Die Verwendung einer zweiten Steuer- und/oder Auswerteeinrichtung ist insbesondere von Vorteil bei Verwendung einer eingangs beschriebenen erfindungsgemäßen Messeinrichtung mit einer Funkschnittstelle und einem Kommunikationsprotokoll mit einem geringen Energieverbrauch und entsprechend begrenzter Reichweite.

Die zweite Steuer- und/oder Auswerteeinrichtung kann dabei geeigneter Weise insbesondere ein Host- Computer und/oder ein Server sein, der mit der ersten Steuer- und/oder Auswerteeinrichtung über ein lokales oder globales Netzwerk zur Signal- und/oder Datenübertragung kabelgestützt und/oder drahtlos vernetzt ist.

Die zweite Steuer- und/oder Auswerteeinrichtung kann darüber hinaus ein Mobiltelefon insbesondere eines Servicetechnikers sein.

Die Messdaten und/oder das Signal können dabei von der zweiten Steuer- und/oder Auswerteeinrichtung geeigneter Weise neben weiteren beispielsweise auch statistischen Auswertungen und/oder Aktualisierungen von Protokollen auch dahingehend auswertet werden, dass ein dem Auswerteergebnis entsprechendes Signal an die erste Steuer- und/oder Auswerteeinrichtung und/oder ein Mobiltelefon eines Servicetechnikers erfolgt. Auf diese Weise ist wie vorstehend erwähnt eine wünschenswert zeitnahe Wartung einer insbesondere in einem kritischen Betriebszustand befindlichen zu überwachenden Vorrichtung ermöglicht.

Die erste Steuer- und/oder Auswerteeinrichtung kann daraufhin das von der zweiten Steuer- und/oder Auswerteeinrichtung empfangene Signal dahingehend auswerten, dass ein dem Auswerteergebnis entsprechendes Signal an die Messeinrichtung erfolgt und/oder eine dem Auswerteergebnis entsprechende Taktung eines Abfragezyklus der Messeinrichtung eingerichtet wird.

Das vorstehend beschriebene Verfahren, kann auf diese Weise optimiert angepasst auf unterschiedliche Installationseinheiten unter Berücksichtigung insbesondere auch deren Energieverbrauchs angewendet werden. Wie vorstehend gesagt ermöglicht das Verfahren auch deren wünschenswert zeitnahe Wartung.

Ein weiteres nicht beanspruchtes Beispiel betrifft außerdem insbesondere ein zur Durchführung eines vorstehend beschriebenen erfindungsgemäßen Verfahrens geeignetes System zur Überwachung des Betriebszustands einer zu überwachenden Vorrichtung und insbesondere zur Überwachung des Betriebszustands der Verbindungen wenigstens eines Steckverbinders.

Ein vorstehendes System umfasst wenigstens eine Messeinrichtung mit wenigstens einem Sensor zur Erfassung von Messdaten wenigstens eines physikalischen Parameters, der den Betriebszustand der zu überwachenden Vorrichtung und insbesondere wenigstens einer mittels einem Steckverbinder bereitgestellten Verbindung charakterisiert. Die Messeinrichtung hat dabei eine Steuereinheit mit einem Mikrokontroller, der eine Funkschnittstelle aufweist.

Ein vorstehendes System weist dabei außerdem wenigstens eine erste hard- und softwaregestützte Steuer- und/oder Auswerteeinrichtung auf, wobei die Messeinrichtung und die erste Steuer- und/oder Auswerteeinrichtung zum drahtlosen bidirektionalen Signal- und/oder Datenaustausch eingerichtet sind.

Die vorstehend beschriebenen Vorteile eines Verfahrens, wie beispielsweise dessen vielfältige Einsatzmöglichkeiten für Installationseinheiten vieler Anwendungen und die Ermöglichung einer zeitnahen Wartung gelten in gleicher Weise für ein erfindungsgemäßes System.

Ein vorstehendes System kann geeigneter Weise insbesondere wenigstens eine eingangs beschriebene Messeinrichtung mit einer autarken Elektronik und einem Mittel zur Energieversorgung aufweisen, das eine Batterie, ein Superkondensator oder eine Hybridbatterie sein kann, und ist wie vorstehend beschrieben vorteilhaft einfach und kostengünstig zu installieren. Bezüglich der sich hieraus ergebenden weiteren Vorteile wird hier auf die vorstehende Beschreibung der erfindungsgemäßen Messeinrichtung verwiesen.

Ein vorstehendes System kann darüber hinaus besonders vorteilhaft wenigstens eine zweite hard- und softwaregestützte Steuer- und/oder Auswerteeinrichtung aufweisen, wobei die erste Steuer- und/oder Auswerteeinrichtung und die zweite Steuer- und/oder Auswerteeinrichtung zum bidirektionalen Signal- und/oder Datenaustausch eingerichtet sind.

Wie vorstehend zu dem Verfahren gesagt kann die zweite Steuer- und/oder Auswerteeinrichtung geeigneter Weise insbesondere ein Host- Computer und/oder ein Server und/oder ein Mobiltelefon sein, die mit der ersten Steuer- und/oder Auswerteeinrichtung über ein lokales oder globales Netzwerk zur Signal- und/oder Datenübertragung kabelgestützt und/oder drahtlos vernetzt sind.

### Ausführungsbeispiele

Ausführungsbeispiele der Erfindung sind in den Zeichnungen dargestellt und werden im Folgenden näher erläutert. Es zeigen:
- Fig. 1A: eine Messeinrichtung nach einer Ausführung der Erfindung;
- Fig. 1B: die Messeinrichtung von Fig. 1A in ihre wesentlichen Bestandteile zerlegt;
- Fig. 1C: die Innenseite eines Blindstopfens nach einer Ausführung der Erfindung;
- Fig. 1D: die Messeinrichtung von Fig. 1A in dem Blindstopfen von Fig. 1C;
- Fig. 2A: einen mit einem Blindstopfen von Fig. 1D versehenen Steckverbinder;
- Fig. 2B: einen Teil eines Gehäuses eines weiteren mit einem Blindstopfen von Fig. 1D versehenen Steckverbinders;
- Fig. 2C: das Gehäuse von Fig. 2B von Innen;
- Fig. 3A: eine Messeinrichtung nach einer weiteren nicht erfindungsgemäßen Ausführung;

- Fig. 3B: die Messeinrichtung von Fig. 3A in ihre wesentlichen Bestandteile zerlegt; und
- Fig. 4: eine schematische Darstellung der wesentlichen Komponenten eines zur Durchführung eines Verfahrens geeigneten Systems,

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

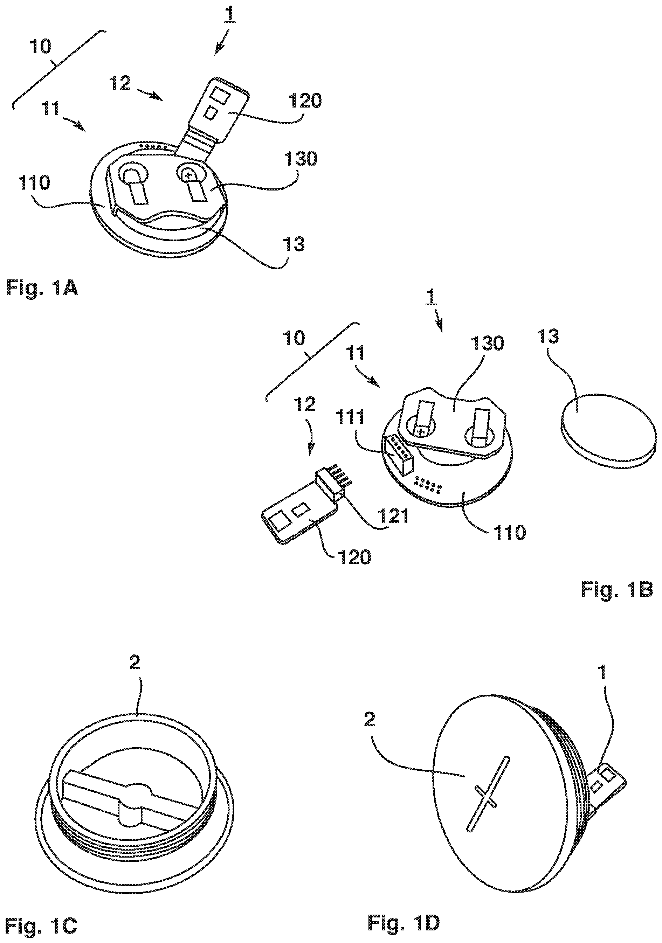

Fig. 1A zeigt eine Messeinrichtung 1 nach einer besonders vorteilhaften Ausführung der Erfindung und Fig. 1B die Messeinrichtung 1 von Fig. 1A in ihre wesentlichen Bestandteile zerlegt. Die Messeinrichtung 1 von Fig. 1A und 1B ist besonders geeignet zur Überwachung einer Vorrichtung 3, die derart ausgebildet ist, dass sie eine zumindest teilweise Anordnung der Messeinrichtung 1 im Inneren ihres Gehäuses 30 gestattet, wobei die Vorrichtung 3 insbesondere ein Steckverbinder 3 sein kann.

Die Messeinrichtung 1 weist eine autarke Elektronik 10 mit einer Steuereinheit 11 und mit einer Batterie 13 als Mittel zur Energieversorgung auf. Die Batterie 13 ist geeigneter Weise eine Knopfzelle mit einer Kapazität von mindestens 70 mAh und vorzugsweise mindestens 180 mAh und mit einer Nennspannung von 2,5V bis 4,5V, die vorteilhaft flach zylindrisch ausgebildet ist.

Die Batterie 13 ist in einem Batteriehalter auf einer ersten Leiterplatte 110 der Steuereinheit 11 vorgesehen, wobei die Raumform der ersten Leiterplatte 110 entsprechend den Abmessungen der Batterie 13 geeigneter Weise kreisförmig ausgebildet ist. Die Steuereinheit ist dementsprechend vorteilhaft kompakt ausgebildet.

Die Elektronik 10 der Steuereinheit 11 weist neben dem Batteriehalter einen auf der Leiterplatte 110 angeordneten Mikrokontroller auf, der eine geeignete Funkschnittstelle zur Daten- und/oder Signalübertragung zu einer in der Zeichnung nicht dargestellten ersten Steuer- und/oder Auswerteeinrichtung bereitstellt.

Die Elektronik 10 der Steuereinheit 11 weist weiterhin eine Busschnittstelle und einen auf der ersten Leiterplatte 110 ausgebildeten ersten Anschluss 111 auf, der mit einem zweiten Anschluss 121 einer zweiten Leiterplatte 120 einer Sensoreinheit 12 derart korrespondiert, dass die Leiterplatte 110 der Steuereinheit 11 mit der Sensoreinheit 12 bestückbar ist.

Die zweite Leiterplatte 120 der Sensoreinheit 12 weist den mit dem Anschluss 111 der ersten Leiterplatte 110 korrespondierenden zweiten Anschluss 121 und wenigstens einen Sensor auf, der zur Erfassung eines physikalischen Parameters geeignet ist, der den Betriebszustand wenigstens einer Verbindung eines Steckverbinders 3 charakterisieren kann.

Die über den ersten Anschluss 111 und den zweiten Anschluss 121 auf die Leiterplatte 110 der Steuereinheit 11 bestückte Sensoreinheit 12 erstreckt sich derart im Wesentlichen senkrecht von der Leiterplatte 110, dass der auf der Sensoreinheit 12 angeordnete Sensor von der Steuereinheit 11 beabstandet ist.

Die Sensoreinheit 12 ist dabei derart ausgebildet und angeordnet, dass sie nicht radial seitlich über den umlaufenden Rand der kreisförmigen Leiterplatte 110 hinausragt. Die Messeinrichtung 1 mit der Sensoreinheit 12 und der Steuereinheit 11 ist auf diese Weise radial besonders kompakt ausgebildet und insbesondere zur zumindest teilweisen Beherbergung in einem nachfolgend unter Bezugnahme auf Fig. 1C und 1D beschriebenen Blindstopfen 2 geeignet. Der Blindstopfen 2 bildet dabei ein Gehäuse 2 der Messeinrichtung 1. Der auf der Sensoreinheit 12 befindliche Sensor ist dabei außerdem wünschenswert axial von der Steuereinheit 11 beabstandet.

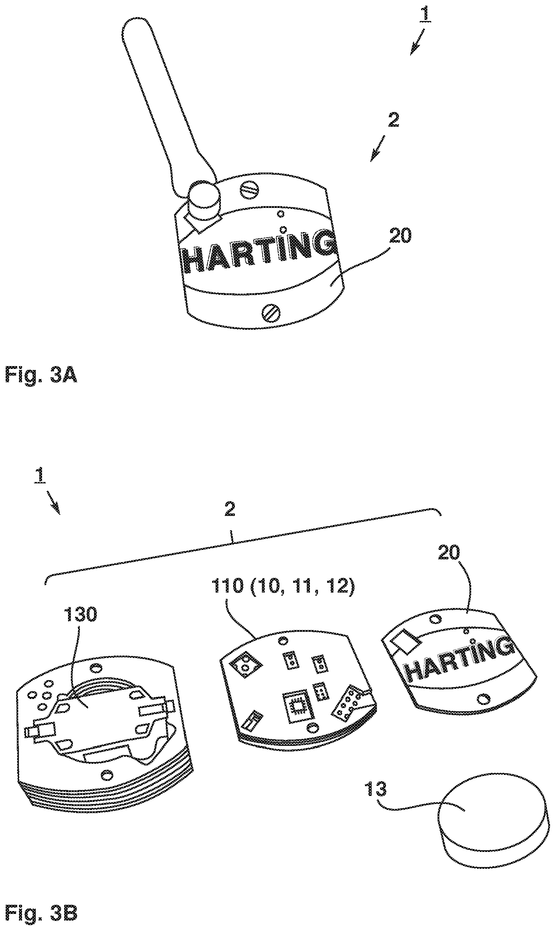

Fig. 1C zeigt die Innenseite eines vorstehend erwähnten Blindstopfens 2 nach einer Ausführung der Erfindung, der insbesondere für eine Kabeldurchführung 31 durch ein Gehäuse 30 eines Steckverbinders 3 geeignet ist. Beispiele eines Steckverbinders 3 mit einer derartigen Kabeldurchführung 31 werden nachfolgend unter Bezugnahme auf Fig. 3A, 3B und 3C beschrieben.

Der Blindstopfen 2 ist erfindungsgemäß im Wesentlichen als Hohlzylinder ausgebildet, der ein Außengewinde aufweist, das mit einem Innengewinde einer Kabeldurchführung 31 derart korrespondiert, dass der Blindstopfen 2 geeignet ist, derart in eine Kabeldurchführung 31 geschraubt zu werden, dass mittels dem Blindstopfen 2 ein Gehäuse 30 eines Steckverbinders 3 dicht verschlossen ist.

Der zylindrische Blindstopfen 2 hat auf der einen Seite seines Zylinders einen Kopf, der radial seitlich geringfügig über den Zylinder hinausragt, so dass der Kopf bei einem mit einer Kabeldurchführung 31 verschraubten Blindstopfen 2 außenseitig benachbart zu dem Gehäuse 30 angeordnet ist.

Der Blindstopfen 2 ist wenigstens teilweise aus einem elektrisch nichtleitenden Material bereitgestellt, so dass der Blindstopfen 2 geeignet ist, die Funktion der Funkschnittstelle der Steuereinheit 11 der Messeinrichtung 1 zu gewährleisten.

Fig. 1D zeigt die Messeinrichtung 1 von Fig. 1A in dem Blindstopfen 2 von Fig. 1C angeordnet, wobei die kreisförmige Leiterplatte 110 der Steuereinheit 11 in dem zylindrischen Blindstopfen 2 angeordnet ist und beispielsweise mit dem Blindstopfen 2 verklebt sein kann.

Die Sensoreinheit 12 ragt dabei vorteilhaft aus dem Hohlzylinder des Blindstopfens 2 heraus und ist in Fig. 1D teilweise sichtbar, während die Steuereinheit 11 der Messeinrichtung in der Zeichnung insbesondere durch den Kopf des Blindstopfens 2 verdeckt ist.

Bei einem Sensor nach Fig. 1A-D kann ein Sensoreinheit 12 sowohl innen (wie zu sehen) als auch außen sein. So ist es z.B. möglich, die Innentemperatur mit der Außentemperatur zu vergleichen. Das ist beispielsweise relevant für die Bewertung, ob eine Temperaturerhöhung im Steckverbinder durch zu hohe Ströme und/oder einem Defekt oder durch eine höhere Außentemperatur zustande kommt. Gleiches gilt auch Feuchtigkeits- oder Lichtsensoren.

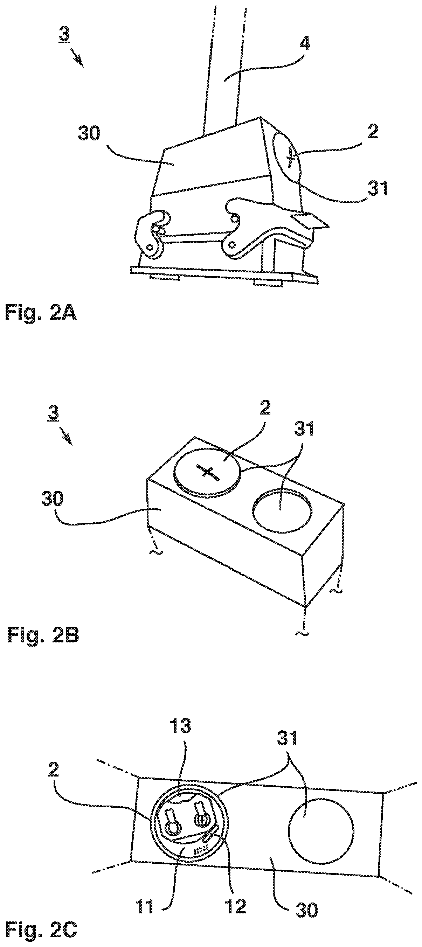

Fig. 2A zeigt einen mit einem Blindstopfen 2 von Fig. 1D versehenen Steckverbinder 3 mit einem Gehäuse 30 und einem Kabel 4, das durch eine Kabeldurchführung von oben in das Innere des Gehäuses 30 des Steckverbinders 3 geführt ist. Der Steckverbinder 3 ist dabei mit einem für ihn vorgesehenen Anschluss verbunden. Der Steckverbinder 3 ist dabei eine von der Messeinrichtung 1 zu überwachende Vorrichtung 3.

Das Gehäuse 30 des Steckverbinders bzw. der zu überwachenden Vorrichtung 3 von Fig. 2A weist seitlich eine weitere nicht genutzte Kabeldurchführung 31 auf, die von einem mit einer Messeinrichtung 1 versehenen Blindstopfen 2 von Fig. 1D verschlossen ist. Dabei ragt die Sensoreinheit 12 wie in Fig. 2D dargestellt axial aus dem zylindrischen Blindstopfen 2 heraus und erstreckt sich in das Innere des Gehäuses 30. Auf diese Weise ist ein Sensor der Sensoreinheit 12 vorteilhaft im Inneren des Gehäuses 30 des Steckverbinders 3 angeordnet.

Fig. 2B zeigt einen Teil eines Gehäuses 30 eines weiteren mit einem Blindstopfen von Fig. 1D versehenen Steckverbinders 3, wobei in der Zeichnung der Einfachheit und Übersichtlichkeit lediglich ein hier interessierender oberer Teil des Gehäuses 30 mit zwei Kabeldurchführungen 31 dargestellt ist. Dabei ist eine der beiden Kabeldurchführungen 31 mit einem Blindstopfen 2 versehen, während die andere Kabeldurchführung 31 offen ist.

Fig. 2C zeigt das Gehäuse 30 von Fig. 2B von Innen. Die Messeinrichtung 1 mit der Steuereinheit 11, der Batterie 13 und der sich aus dem Blindstopfen 2 heraus und in das Innere das Gehäuses 30 erstreckenden Sensoreinheit 12 ist in dem Blindstopfen 2 angeordnet.

Für eine wünschenswerte weitere Beabstandung des Sensors der Sensoreinheit 12 von der Steuereinheit 11 und dem Blindstopfen 2 kann ein in den Zeichnungen nicht dargestelltes Adapterkabel die Anschlüsse 111 und 121 verbinden. Auf diese Weise kann ein auf der Sensoreinheit 12 angeordneter Sensor an einer vorbestimmten Position von besonderem Interesse insbesondere auch in der Nachbarschaft einer mittels einem Steckverbinder 3 bereitgestellten insbesondere elektrischen Verbindung im Inneren des Gehäuses 30 des Steckverbinders 3 angeordnet werden.

Fig. 3A zeigt eine Draufsicht auf eine hard- und softwaregestützte Messeinrichtung 1 mit einem Gehäuse 2 nach einer weiteren beispielhaften Ausführung, die der Erfindung nicht entspricht, und Fig. 3B zeigt die Messeinrichtung 1 von Fig. 3A in ihre wesentlichen Bestandteile zerlegt.

Die Elektronik 10 der Messeinrichtung 1 ist auf einer ersten Leiterplatte 110 vorgesehen, die mit elektrischen und elektronischen Bauelementen einer Steuereinheit 11 und einer Sensoreinheit 12 bestückt ist, die der Einfachheit halber in Fig. 3B nicht auf der ersten Leiterplatte 110 dargestellt sind. Ansonsten entspricht die Elektronik 10 der vorstehend unter Bezugnahme auf Fig. 1A und 1B beschriebenen Messeinrichtung 1.

Das Gehäuse 2 hat eine obere Abdeckung 2 mit einer Ausnehmung für einen Anschluss einer externen Antenne und mit weiteren Ausnehmungen für den Kontakt von ausgewählten Sensoren mit der Umgebung des Gehäuses 2. In einem unteren Gehäuseteil ist ein Batteriehalter 130 für eine Batterie 13 als Mittel zur Energieversorgung der Elektronik 10 vorgesehen. Die erste Leiterplatte 110 ist dabei sandwichartig zwischen dem unteren Gehäuseteil und der Abdeckung 20 angeordnet.

Wie der vorstehend beschriebene Blindstopfen 2 besteht das Gehäuse 2 der Messeinrichtung von Fig. 3A und 3B aus zumindest teilweise aus einem nichtleitenden Material.

An dem seitlichen Rand des Gehäuses 2 sind zwei gegenüberliegende durchgehende Bohrungen zur Befestigung der Messeinrichtung 1 an ihrer bestimmungsgemäßen Position an einer zu überwachenden Vorrichtung mittels Schrauben vorgesehen. Die Messeinrichtung 1 von Fig. 3A und 3B ist besonders geeignet zur Überwachung des Betriebszustands einer Maschine.

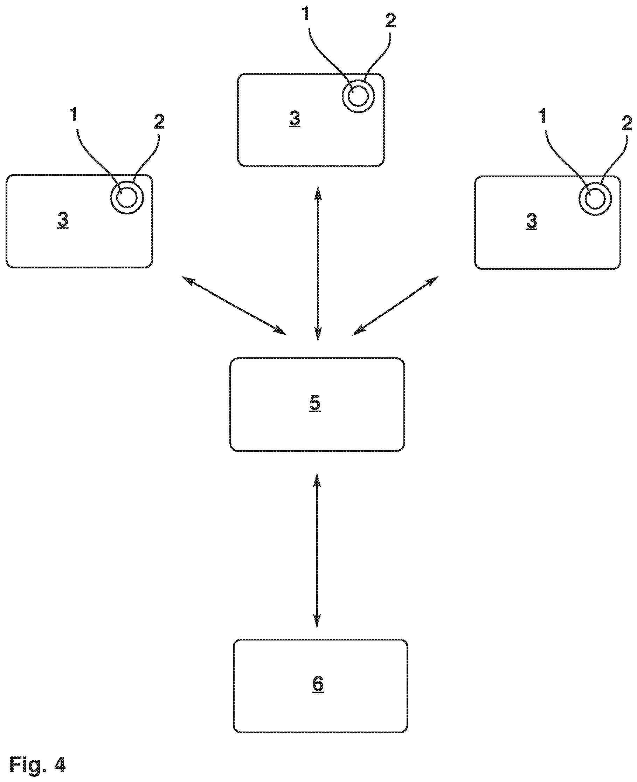

Fig. 4 zeigt eine schematische Darstellung der wesentlichen Komponenten eines zur Durchführung eines Verfahrens geeigneten Systems.

Das System von Fig. 4 umfasst beispielhaft drei an einer zu überwachenden Vorrichtung 3 angeordneten Messeinrichtungen 1 mit einem Gehäuse 2, das an der Vorrichtung 3 angeordnet ist. Gegenüber den Darstellungen von Fig. 1A, 1D und 2A sind die Messeinrichtung 1, das Gehäuse 2 und die Vorrichtung 3 in Fig. 3 vergleichsweise stark schematisiert. Die Messeinrichtungen 1 können beispielsweise wie die Messeinrichtung 1 von Fig. 1A und 1B ausgebildet sein, und die zu überwachenden Vorrichtungen 3 können beispielsweise zu überwachende Steckverbinder 3 sein.

Das System von Fig. 4 weist dabei außerdem eine erste hard- und softwaregestützte Steuer- und/oder Auswerteeinrichtung 5 auf, wobei die Messeinrichtungen 1 und die erste Steuer- und/oder Auswerteeinrichtung 5 zum drahtlosen bidirektionalen Signal- und/oder Datenaustausch eingerichtet sind.

Das System von Fig. 4 weist dabei vorteilhaft außerdem eine zweite hard- und softwaregestützte Steuer- und/oder Auswerteeinrichtung 6 auf, wobei die erste Steuer- und/oder Auswerteeinrichtung 5 und die zweite Steuer- und/oder Auswerteeinrichtung 6 zum bidirektionalen Signal- und/oder Datenaustausch eingerichtet sind.

Ein System 3 gemäß Fig. 4 ist zur Durchführung eines eingangs beschriebenen Verfahrens besonders geeignet, bei dem die erste Steuer- und/oder Auswerteeinrichtung 5 mit den Messeinrichtungen 1 zur drahtlosen Signal- und/oder Datenübermittlung miteinander verbunden sind, und die erste Steuer- und/oder Auswerteeinrichtung 5 darüber hinaus mit der zweiten erste Steuer- und/oder Auswerteeinrichtung 6 kabelgestützt und/oder drahtlos verbunden ist.

Die zweite Steuer- und/oder Auswerteeinrichtung 6 kann dabei geeigneter Weise insbesondere ein Host- Computer und/oder ein Server sein, der mit der ersten Steuer- und/oder Auswerteeinrichtung 5 über ein lokales oder globales Netzwerk zur Signal- und/oder Datenübertragung vernetzt ist. Nach einer Abwandlung der Ausführung des Systems von Fig. 4 kann die zweite Steuer- und/oder Auswerteeinrichtung 6 wie vorstehend beschrieben ein Mobiltelefon sein.

### Messeinrichtung für Betriebszustand

### Bezugszeichenliste

- 1: Messeinrichtung
- 10: Elektronik
- 11: Steuereinheit
- 110: erste Leiterplatte
- 111: erster Anschluss
- 12: Sensoreinheit
- 120: zweite Leiterplatte
- 121: zweiter Anschluss
- 13: Mittel zur Energieversorgung, Batterie
- 130: Batteriehalter

- 2: Gehäuse, Blindstopfen
- 20: Abdeckung

- 3: Vorrichtung, Steckverbinder
- 30: Gehäuse
- 31: Kabeldurchführung

- 4: Kabel

- 5: erste Steuer- und/oder Auswerteeinrichtung

- 6: zweite Steuer- und/oder Auswerteeinrichtung

## Patentansprüche

1. Vorrichtung (3), aufweisend ein Gehäuse (30) mit einer nicht verwendeten Kabeldurchführung (31) und eine Hard- und Softwaregestützte Messeinrichtung (1) für die Vorrichtung (3),
wobei die Messeinrichtung (1) wenigstens einen Sensor zur Erfassung von Messdaten wenigstens eines physikalischen Parameters aufweist, der den Betriebszustand der Vorrichtung (3) charakterisiert,
wobei die Messeinrichtung (1) eine autarke Elektronik (10) mit einer Steuereinheit (11) und ein Mittel zur Energieversorgung (13) aufweist, und
wobei die Steuereinheit (11) einen Mikrocontroller aufweist, der eine Funkschnittstelle zur Daten- und/oder Signalübertragung zu einer Steuer- und/oder Auswerteeinrichtung (5) aufweist,
wobei die Messeinrichtung (1) ein für die nicht verwendete Kabeldurchführung (31) durch das Gehäuse (30) der Vorrichtung (3) vorgesehenes und entsprechend als deren Blindstopfen (2) ausgebildetes Gehäuse (2) aufweist, in dem die Messeinrichtung (1) zumindest teilweise angeordnet ist, wobei das Gehäuse (2) der Messeinrichtung (1) nachrüstbar an der Vorrichtung (3) befestigt ist
**dadurch gekennzeichnet, dass**
der Blindstopfen (2) im Wesentlichen als Hohlzylinder ausgebildet ist, und ein Außengewinde ausweist, das dazu geeignet ist, mit einem Innengewinde der Kabeldurchführung (31) der Vorrichtung (3) derart zu korrespondieren und geschraubt zu werden, dass mittels dem Blindstopfen (2) das Gehäuse (30) der Vorrichtung (3) dicht verschließbar ist.

2. Vorrichtung (3) nach Anspruch 1, wobei die Funkschnittstelle für das Kommunikationsprotokoll BLE (Blue Tooth Low Energy) eingerichtet ist und dabei einen Energieverbrauch von weniger als 1W und vorzugsweise von weniger als 0.5W und besonders bevorzugt von weniger als 0.1W aufweist und einen Spitzenstromverbrauch von weniger als 30mA und vorzugsweise weniger als 15mA aufweist, und wobei die Steuereinheit (11) eine Chip-Antenne aufweist oder mit einer externen aus dem Blindstopfen nach außen herausragenden Antenne verbunden ist

3. Vorrichtung (3) nach einem der Ansprüche 1 oder 2, wobei die Steuereinheit (11) eine Busschnittstelle aufweist, und über die Busschnittstelle mit einer Sensoreinheit (12) bestückt ist, die den Sensor aufweist.

4. Vorrichtung (3) nach Anspruch 3, wobei
die Elektronik (10) der Steuereinheit (11) auf einer ersten Leiterplatte (110) mit einem ersten Anschluss (111) bereitgestellt ist, und
die Elektronik (10) der Sensoreinheit (12) auf einer zweiten Leiterplatte (120) mit einem zweiten Anschluss (121) bereitgestellt ist, wobei
der erste Anschluss (111) mit dem zweiten Anschluss (121) derart korrespondiert, dass die Steuereinheit (11) mit der Sensoreinheit (12) bestückbar ist.

5. Vorrichtung (3) nach Anspruch 4, wobei die Sensoreinheit (12) mittels einem Adapterkabel von der Steuereinheit (11) beabstandet ist, und die erste Leiterplatte (110) kreisförmig ausgebildet ist, und die Sensoreinheit (12) nicht über den seitlichen Rand der ersten Leiterplatte (110) hinausragt.

6. Vorrichtung (3) nach einem der Ansprüche 2 bis 5, wobei die Steuereinheit (11) einen Batteriehalter aufweist, und das Mittel zur Energieversorgung eine Batterie (13) mit einer Kapazität von mindestens 70 mAh und vorzugsweise mindestens 180 mAh und mit einer Nennspannung von 2,5V bis 4,5V ist, wobei die Steuereinheit (11) derart ausgebildet und eingerichtet ist, dass die Messeinrichtung (1) eine durchschnittliche Leistungsaufnahme von wenige als 100µA und vorzugswiese von weniger als 50µA aufweist.

7. Vorrichtung (3) nach einem der Ansprüche 1 bis 6, mit einem Sensor zur Erfassung der Stromstärke, die über Kontakte einer elektrischen Verbindung geführt wird, und/oder einem Sensor zur Erfassung der dabei herrschenden Temperatur und/oder einem Feuchtigkeitssensor und/oder einem Beschleunigungssensor und/oder einem Hall-Sensor und/oder einem Magnet Sensor und/oder einem Lichtsensor, und wobei die Messeinrichtung (1) wenigstens einen Aktor aufweist, der eine LED sein kann.

8. Vorrichtung (3) nach einem der Ansprüche 1 bis 7, wobei
die Vorrichtung (3) ein Steckverbinder (3) ist, und
das Gehäuse (2) wenigstens teilweise aus einem elektrisch nichtleitenden Material bereitgestellt ist.

## Claims

1. Device (3) comprising a housing (30) having an unused cable feedthrough (31) and a hardware- and software-based measuring apparatus (1) for the device (3),
wherein the measuring apparatus (1) comprises at least one sensor for capturing measurement data relating to at least one physical parameter that characterizes the operating state of the device (3),
wherein the measuring apparatus (1) comprises autonomous electronics (10) having a control unit (11) and a means for supplying power (13), and
wherein the control unit (11) comprises a microcontroller that comprises a radio interface for data and/or signal transmission to a control and/or analysis apparatus (5), wherein the measuring apparatus (1) comprises a housing (2) intended for the unused cable feedthrough (31) through the housing (30) of the device (3) and accordingly embodied as the blanking plug (2) thereof, in which housing (2) at least part of the measuring apparatus (1) is arranged, wherein
the housing (2) of the measuring apparatus (1) is fastened to the device (3) in a retrofittable manner, **characterized in that**
the blanking plug (2) is essentially embodied as a hollow cylinder and comprises an external thread which is suitable for corresponding to an internal thread of the cable feedthrough (31) of the device (3) and being screwed such that the blanking plug (2) is able to tightly seal the housing (30) of the device (3).

2. Device (3) according to Claim 1, wherein
the radio interface is configured for the BLE (Bluetooth Low Energy) communications protocol and in this case has a power consumption of less than 1 W and preferably of less than 0.5 W and more preferably of less than 0.1 W, and has a peak current consumption of less than 30 mA and preferably of less than 15 mA, and wherein
the control unit (11) comprises a chip antenna or is connected to an external antenna that extends outwards out of the blanking plug.

3. Device (3) according to either of Claims 1 and 2, wherein
the control unit (11) comprises a bus interface and via the bus interface is fitted with a sensor unit (12) comprising the sensor.

4. Device (3) according to Claim 3, wherein
the electronics (10) of the control unit (11) are provided on a first printed circuit board (110) having a first connecting terminal (111), and
the electronics (10) of the sensor unit (12) are provided on a second printed circuit board (120) having a second connecting terminal (121), wherein
the first connecting terminal (111) corresponds to the second connecting terminal (121) such that the control unit (11) is able to be fitted with the sensor unit (12).

5. Device (3) according to Claim 4, wherein
the sensor unit (12) is spaced from the control unit (11) by means of an adapter cable, and the first printed circuit board (110) has a circular design, and the sensor unit (12) does not protrude beyond the lateral edge of the first printed circuit board (110).

6. Device (3) according to one of Claims 2 to 5, wherein the control unit (11) comprises a battery holder, and the means for supplying power is a battery (13) having a capacity of at least 70 mAh and preferably of at least 180 mAh and having a rated voltage of 2.5 V to 4.5 V, wherein
the control unit (11) is designed and configured such that the measuring apparatus (1) has an average power consumption of less than 100 µA and preferably of less than 50 µA.

7. Device (3) according to one of Claims 1 to 6, comprising a sensor for detecting the current carried via contacts of an electrical connection, and/or a sensor for detecting the prevailing temperature here and/or a humidity sensor and/or an accelerometer and/or a Hall sensor and/or a magnet sensor and/or a light sensor, and wherein
the measuring apparatus (1) comprises at least one actuator, which may be an LED.

8. Device (3) according to one of Claims 1 to 7, wherein the device (3) is a plug-in connector (3), and
the housing (2) is provided at least in part from an electrically non-conducting material.

## Revendications

1. Arrangement (3), possédant un boîtier (30) pourvu d'une traversée de câble (31) non utilisée et d'un dispositif de mesure (1) assistée par matériel et par logiciel pour l'arrangement (3),
le dispositif de mesure (1) possédant au moins un capteur destiné à acquérir des données de mesure d'au moins un paramètre physique qui caractérise l'état opérationnel de l'arrangement (3),
le dispositif de mesure (1) possédant une électronique (10) autonome pourvue d'une unité de commande (11) et un moyen d'alimentation en énergie (13), et
l'unité de commande (11) possédant un microcontrôleur, lequel possède une interface radioélectrique destinée à la transmission de données et/ou de signaux vers un dispositif de commande et/ou d'évaluation (5),
le dispositif de mesure (1) possédant un boîtier (2), prévu pour la traversée de câble (31) non utilisée à travers le boîtier (30) de l'arrangement (3) et configuré en conséquence comme son bouchon obturateur (2), dans lequel est disposé au moins partiellement le dispositif de mesure (1),
le boîtier (2) du dispositif de mesure (1) étant fixé à l'arrangement (3) de manière à pouvoir être monté ultérieurement,
**caractérisé en ce que**
le bouchon obturateur (2) est réalisé sensiblement sous la forme d'un cylindre creux et possède un filetage mâle qui est adapté pour correspondre et pour être vissé avec un filetage femelle de la traversée de câble (31) de l'arrangement (3) de telle sorte que le boîtier (30) de l'arrangement (3) peut être fermé hermétiquement au moyen du bouchon obturateur (2).

2. Arrangement (3) selon la revendication 1, l'interface radioélectrique étant conçue pour le protocole de communication BLE (Bluetooth Low Energy - Bluetooth à basse consommation) et présente ici une consommation d'énergie inférieure à 1 W et de préférence inférieure à 0,5 W et notamment de préférence inférieure à 0,1 W et présente une consommation de courant de crête inférieure à 30 mA et de préférence inférieure à 15 mA, et l'unité de commande (11) possédant une antenne à puce ou étant reliée à une antenne externe qui fait saillie vers l'extérieur depuis le bouchon obturateur.

3. Arrangement (3) selon l'une des revendications 1 ou 2, l'unité de commande (11) possédant une interface de bus et étant équipée, par le biais de l'interface de bus, d'une unité de capteur (12) qui possède le capteur.

4. Arrangement (3) selon la revendication 3, l'électronique (10) de l'unité de commande (11) étant fournie sur une première carte à circuit imprimé (110) pourvue d'une première borne (111) et
l'électronique (10) de l'unité de capteur (12) étant fournie sur une deuxième carte à circuit imprimé (120) pourvue d'une deuxième borne (121),
la première borne (111) correspondant à la deuxième borne (121) de telle sorte que l'unité de commande (11) peut être équipée de l'unité de capteur (12).

5. Arrangement (3) selon, la revendication 4, l'unité de capteur (12) étant espacée de l'unité de commande (11) au moyen d'un câble adaptateur, et la première carte à circuit imprimé (110) étant de configuration circulaire, et l'unité de capteur (12) .ne faisant pas saillie du bord latéral de la première carte à circuit imprimé (110).

6. Arrangement (3) selon l'une des revendications 2 à 5,
l'unité de commande (11) possédant un support de pile/batterie, et le moyen d'alimentation en énergie étant une pile/batterie (13) ayant une capacité d'au moins 70 mAh et de préférence d'au moins 180 mAh et ayant une tension nominale de 2,5 V à 4,5 V,
l'unité de commande (11) étant configurée et conçue de telle sorte que le dispositif de commande (1) présente une puissance consommée moyenne inférieure à 100 µA et de préférence inférieure à 50 µA.

7. Arrangement (3) selon l'une des revendications 1 à 6, comprenant un capteur destiné à détecter l'intensité de courant qui passe par les contacts d'une connexion électrique et/ou un capteur destiné à détecter la température qui règne ici et/ou un capteur d'humidité et/ou un capteur d'accélération et/ou un capteur à effet Hall et/ou un capteur magnétique et/ou un capteur de lumière, et
le dispositif de mesure (1) possédant au moins un actionneur, qui peut être une LED.

8. Arrangement (3) selon l'une des revendications 1 à 7, l'arrangement (3) étant un connecteur à enficher (3) et le boîtier (2) étant fourni au moins partiellement en un matériau non conducteur d'électricité.
